# EUROPÄISCHE PATENTSCHRIFT

(11) **EP 1 574 869 B1**
(45) Veröffentlichungstag und Bekanntmachung des Hinweises auf die Patenterteilung: **05.12.2007**
(21) Anmeldenummer: 05005098.8
(22) Anmeldetag: 09.03.2005
(51) Int. Cl.: G01R 31/30, G01R 31/02, G01R 31/00

(54) **Schaltungsanordnung zur Detektion eines Kriech- oder Defektstroms**
Circuit for detecting a leakage current
Circuit de détection d'un courant de fuite

(30) Priorität: 12.03.2004 DE 102004012102
(43) Veröffentlichungstag der Anmeldung: 14.09.2005
(73) Patentinhaber: KNORR-BREMSE SYSTEME FÜR NUTZFAHRZEUGE GMBH, 80809 München (DE)
(72) Erfinder: Scholl, Frank, 74379 Ingersheim (DE); Herrmann, Günter, 70569 Stuttgart (DE)
(74) Vertreter: Schönmann, Kurt

(56) Entgegenhaltungen:
- EP-A- 0 418 665
- EP-A- 1 059 537
- DE-A1- 3 900 040
- US-A- 5 962 934
- US-A- 6 115 831

## Beschreibung

Die Erfindung betrifft eine Schaltungsanordnung zur Detektion eines Kriech- oder Defektstroms, mittels derer die Spannungsversorgung einer elektronischen Schaltung abschaltbar ist sowie ein Verfahren zum Betreiben einer derartigen Schaltungsanordnung.

Bei aufgrund ihres Einsatzortes Umwelteinflüssen ausgesetzten elektronischen Steuergeräten können bei Beschädigung des Schutzgehäuses Undichtigkeiten entstehen, durch die Fremdstoffe in den Elektronikraum eindringen können, welche die Funktion stören und sogar einen Brand auslösen können. Elektrolythaltige Spritzwassereinträge, insbesondere Salzlösungen stellen eine solche Gefahr dar. Gelangt Salzlösung zwischen spannungsführende Kontaktstellen, fließt ein ionischer Fehlstrom. Durch die damit verbundene Elektrolyse kann dies in bestimmten Situationen zum Brand führen. Solange die elektronische Funktionalität des Steuergeräts nicht in der Weise beeinflusst wird, dass das Steuergerät wegen Fehlfunktion abgeschaltet wird, wird die brandfördemde elektrolytische Produktion von beispielsweise Wasserstoff und Chlorgas fortgesetzt. Diese Problematik von Umwelteinflüssen ausgesetzten elektronischen Steuergeräten wiegt insbesondere in der Fahrzeugindustrie schwer, bei der gerade im Nutzfahrzeugsektor elektronische Steuergeräte direkt am Lkw-Rahmen angebracht und dem aufspritzenden Salzwasser der winterlichen Straße voll ausgesetzt sind. Eine in einem beschädigten Steuergerät nicht erkannte Produktion von Elektrolysegasen und ein dadurch ausgelöster Brand können insbesondere in einem Tunnel zu verheerenden Personen- und Sachschäden führen.

Elektronische oder mechatronische Komponenten nach dem Stand der Technik, wie sie beispielsweise in der Fahrzeugindustrie solchen Umwelteinflüssen ausgesetzt am Fahrzeugrahmen eingebaut werden, werden in der Regel über eine geschaltete Bordspannung versorgt. Innerhalb solcher Komponenten können Überwachungsschaltungen viele Schaltungsteile abschalten. Die direkt am Stecker der Stromzuführungsleitungen anliegende Spannung kann aber nur von einer Überwachungsschaltung einer vorgeschalteten Komponente abgeschaltet werden. Die Abschaltung kann beispielsweise nach Messung einer überhöhten Stromaufnahme oder im einfachsten Fall durch eine bei überhöhtem Strom ansprechenden Sicherung erfolgen. Mit beginnendem Aufkommen des Elektrolysegase freisetzenden Fehlstroms ist die Änderung der Stromaufnahme aber sehr gering und von der großen Schwankungen unterworfenen regulären Stromaufnahme nicht zu unterscheiden. Zu dem Zeitpunkt, an dem die Elektrolyse zu einem Brand führt, ist zwar eine signifikante Stromerhöhung messbar, zur Verhinderung eines Brandes hätte die Stromzufuhr aber bereits vorher abgeschaltet werden müssen.

Aus der US 962 934 A1 und der DE 3900040A1 sind Vorrichtungen zur Detektierung von Detektströmen bekannt.

Der Erfindung liegt die Aufgabe zugrunde, eine Schaltungsanordnung zur Detektion eines Kriech- oder Defektstroms zu schaffen, mittels derer die Spannungsversorgung einer elektronischen Schaltung mit einsetzendem Fehlstrom abgeschaltet werden kann, bevor der Fehlstrom ein brandgefährdendes Ausmaß erreicht.

Diese Aufgabe wird gelöst durch eine Vorrichtung mit den Merkmalen des Anspruchs 1 und ein Verfahren mit den Merkmalen des Anspruchs 7. Vorteilhafte Ausgestaltungen ergeben sich aus den Unteransprüchen.

Die erfindungsgemäße Schaltungsanordnung zur Detektion eines Kriech- oder Defektstroms, mittels derer die Spannungsversorgung einer elektronischen Schaltung abschaltbar ist, weist eine mit einer Signalleitung verbundene Leiterbahn oder einen isolationsschichtfreien Leiter oder einen isolationsschichtfreien Teil der Signalleitung selbst auf, die / der derart angeordnet ist, dass sie / er eine potentielle Kriechstromverbindungsstrecke eines Kurzschlusses zwischen den Spannungsversorgungsleitungen kreuzt. Darunter, dass die Leiterbahn oder der isolationsschichtfreie Leiter eine potentielle Kriechstromverbindungsstrecke eines Kurzschlusses zwischen den Spannungsversorgungsleitungen kreuzt, ist nicht nur zu verstehen, dass die Leiterbahn oder der isolationsschichtfreie Leiter genau die Verbindungslinie zwischen den Kriechstromeintritts- und -austrittsstellen an den Stromversorgungsleitungen kreuzt, sondern dass sie/er in Bezug auf die Stromverteilung des Kriechstroms diesen anteilig derart durchquert, dass ein dadurch bedingtes elektrisches Signal auf der Signalleitung mit elektronischen Standardmitteln aufnehmbar ist. Der grundsätzliche Erfindungsgedanke hierbei ist, dass die Signalleitung oder eine Stichleitung davon konstruktiv so ausgeführt ist, dass sie von einem Fehlstrom beispielsweise bedingt durch eine Benetzung mit einem lonenleiter wie beispielsweise einer Salzlösung beeinflusst wird. Eine vorgeschaltete elektronische Komponente mit einer Auswerteschaltung kann diese Beeinflussung erkennen und die Versorgungsspannung frühzeitig abschalten und so einen Brand verhindern.

In einer vorteilhaften Ausgestaltung der Erfindung sind die mit einer Signalleitung verbundene Leiterbahn bzw. der isolationsschichtfreie Leiter bzw. der isolationsschichtfreie Teil der Signalleitung zwischen zwei isolationsfreien Anschlussflächen, insbesondere Lötflächen oder Bondflächen der Spannungsversorgungsleitungen angeordnet. Ein Kriechstrom zwischen diesen beiden Kontaktflächen, wie er durch eine Benetzung mit einem Ionenleiter wie beispielsweise einer Salzlösung hervorgerufen wird, wird von der Signalleitung oder einer Stichleitung davon durchquert und setzt diese auf ein Zwischenpotential. Die Signalleitung oder eine Stichleitung davon wirkt wie ein Abnehmer eines Spannungsteilers.

Vorteilhafter Weise ist die Signalleitung eine Sensorleitung oder eine Kommunikationsleitung, insbesondere eine CAN-Bus-Leitung. Damit kann durch eine Auswertung des Sensorsignals bzw. durch eine Auswertung einer Verfälschung des Kommunikationssignals ein Fehlstrom erkannt werden.

Vorzugsweise ist die mit einer Signalleitung verbundene Leiterbahn bzw. der isolationsschichtfreie Leiter eine Stichleitung von einer CAN-Leitung. Durch die Aufnahme des Kriechstrompotentials mit einer Stichleitung eine CAN-Leitung muss deren Leitungsführung nicht verändert werden und die durch den Kriechstrom bedingte Potentialänderung ist auf der CAN-Leitung leicht feststellbar.

Eine Auswertelogik erkennt vorzugsweise einen Kriech- oder Defektstrom an Hand der Potentialhöhe, einer Signalverfälschung oder einer Störung im Datenfluss der Signalleitung.

Die Vorzüge der erfindungsgemäßen Schaltungsanordnung kommen besonders zum tragen, wenn die Schaltungsanordnung Teil einer Elektronik eines Elektronischen Bremssystems EBS ist. Elektronische Schaltungen in elektropneumatischen Modulatoren sind aufgrund der Anbringung der elektropneumatischen Modulatoren an dem Rahmen von Nutzfahrzeugen bei Gehäuse-Undichtigkeiten und Eintrag von Salzwasser von der Straße besonders gefährdet.

In einer Zeichnung ist ein Ausführungsbeispiel der Erfindung dargestellt.

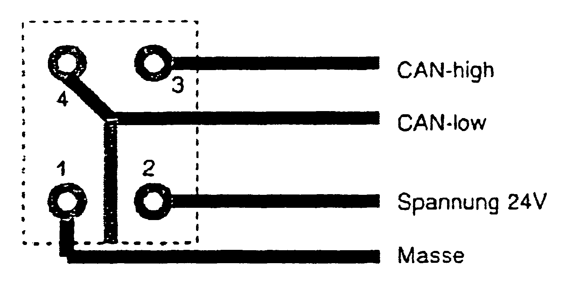

Die einzige Figur zeigt eine Platine einer erfindungsgemäßen Schaltungsanordnung in einer stark vereinfachten, schematisierten Darstellung.

Auf einer Platine sind vier Kontaktpunkte angeordnet, an einem Kontaktpunkt 1 ist eine Masseleitung einer Spannungsversorgung, an einem Kontaktpunkt 2 ist eine 24 V spannungsführende Leitung der Spannungsversorgung, an einem Kontaktpunkt 3 eine "CAN-high" Leitung eines Signalleiterpaares und an einem Kontaktpunkt 4 eine "CAN-low" Leitung eines Signalleiterpaares angebracht. Von der "CAN-low" Leitung des Signalleiterpaares zweigt eine isolationsfreie Stichleitung ab, die genau mittig zwischen den Kontaktpunkten 1 und 2 der Spannungsversorgung hindurchführt und am Rand der Platine frei endet. Wird die Platine mit einer Salzlösungsschicht benetzt, die sich durchgehend von dem Kontaktpunkt 1 bis zum Kontaktpunkt 2 erstreckt und damit eine leitende Verbindung zwischen den beiden Spannungsversorgungskontaktpunkten herstellt, so hat dies einen Fehlstrom zwischen den Spannungsversorgungskontaktpunkten zur Folge. Dieser Fehlstrompfad kreuzt dabei die Stichleitung und setzt sie und damit die "CAN-low" Leitung auf ein Potential zwischen 0 und 24 V. Über diese Potentialänderung kann ein Fehlstrom von einer mit der "CAN-low" Leitung verbundenen Auswertelogik aufgespürt werden. Die Spannungsversorgung wird daraufhin abgeschaltet und der Elektrolyseprozess an den Spannungsversorgungskontaktpunkten bei dem Übergang von elektronischer zu ionischer Leitung unterbunden. Die Brandgefahr infolge der freigesetzten Elektrolysegase ist somit gebannt.

### Bezugszeichen

- 1: Kontaktpunkt
- 2: Kontaktpunkt
- 3: Kontaktpunkt
- 4: Kontaktpunkt

## Patentansprüche

1. Schaltungsanordnung zur Detektion eines Kriech- oder Defektstroms, mittels derer die Spannungsversorgung einer elektronischen Schaltung abschaltbar ist, **dadurch gekennzeichnet, dass** eine mit einer Signalleitung verbundene Leiterbahn oder ein mit einer Signalleitung verbundener isolationsschichtfreier Leiter oder ein isolationsschichtfreier Teil der Signalleitung selbst derart angeordnet ist, dass sie/er eine potentielle Kriech- oder Defektstromverbindungsstrecke eines Kurzschlusses zwischen den Spannungsversorgungsleitungen kreuzt.

2. Schaltungsanordnung nach Anspruch 1, **dadurch gekennzeichnet, dass** die mit einer Signalleitung verbundene Leiterbahn bzw. der isolationsschichtfreie Leiter bzw. der isolationsschichtfreie Teil der Signalleitung zwischen zwei isolationsfreien Anschlussflächen, insbesondere Lötflächen oder Bondflächen der Spannungsversorgungsleitungen angeordnet sind.

3. Schaltungsanordnung nach einem der vorstehenden Ansprüche, **dadurch gekennzeichnet, dass** die Signalleitung eine Sensorleitung oder eine Kommunikationsleitung, insbesondere eine CAN-Bus-Leitung ist.

4. Schaltungsanordnung nach Anspruch 1 oder 2, **dadurch gekennzeichnet, dass** die mit einer Signalleitung verbundene Leiterbahn bzw. der isolationsschichtfreie Leiter eine Stichleitung von einer CAN-Leitung ist.

5. Schaltungsanordnung nach einem der vorstehenden Ansprüche, **dadurch gekennzeichnet, dass** eine Auswertelogik einen Kriech- oder Defektstrom an Hand der Potentialhöhe, einer Signalverfälschung oder einer Störung im Datenfluss der Signalleitung,erkennt.

6. Schaltungsanordnung nach einem der vorstehenden Ansprüche, **dadurch gekennzeichnet, dass** sie Teil einer Elektronik eines Elektronischen Bremssystems EBS ist.

7. Verfahren zum Betreiben einer Schaltungsanordnung nach einem der vorstehenden Ansprüche, **dadurch gekennzeichnet, dass** bei erkanntem Kriech- oder Defektstrom die Spannungsversorgung abgeschaltet wird.

## Claims

1. Circuit for detecting a leakage or creepage current, by means of which the voltage supply of an electronic circuit may be turned off, **characterised in that** a conductor path connected to a signal line or a conductor free of an insulating layer, which is connected to a signal line, or one part of the signal line as such, which is free of an insulating layer, is so disposed that it crosses a potential leakage or creepage current connecting path of a short-circuit between the voltage supply lines.

2. Circuit according to Claim 1, **characterised in that** said conductor path connected to a signal line or said conductor free of an insulating layer or said part of the signal line, which is free of an insulating layer, is disposed between two terminal pads free of an insulation, in particular soldering or bonding areas of said voltage supply lines.

3. Circuit according to any of the preceding Claims, **characterised in that** said signal line is a sensor line or a communication line, in particular a CAN bus line.

4. Circuit according to Claim 1 or 2, **characterised in that** said conductor path connected to a signal line or said conductor free of an insulation is a branch line from a CAN line.

5. Circuit according to any of the preceding Claims, **characterised in that** an analyser logic detects a leakage or creepage current by the magnitude of the potential, by signal adulteration or by failure in the data flow on said signal line.

6. Circuit according to any of the preceding Claims, **characterised in that** it constitutes part of an electronic system in an electronic brake system EBS.

7. Method of operating a circuit according to any of the preceding Claims, **characterised in that** when a leakage or creepage current is detected, the voltage supply is turned off.

## Revendications

1. Circuit à détecter un courant de fuite, moyennant duquel l'alimentation d'un circuit électronique en courant se peut mettre hors circuit, **caractérisé en ce qu'**un piste conductive reliée à un circuit d'acheminement des signaux ou un conducteur sans couche isolante, qui est relié à un circuit d'acheminement des signaux, ou un tronçon du circuit d'acheminement des signaux en soi, qui est libre d'une couche isolante, est disposé d'une telle manière, qu'il croise un voie de connexion potentielle de courant de fuite ou de défaut d'un court-circuit entre les lignes d'alimentation en courant.

2. Circuit selon la revendication 1, **caractérisé en ce que** ladite piste conductive reliée à un circuit d'acheminement des signaux ou ledit conducteur sans couche isolante ou ledit tronçon du circuit d'acheminement des signaux, qui est libre d'une couche isolante, est disposé entre deux pastilles de connexion, en particulier des aires de soudure ou de métallisation desdites lignes d'alimentation en courant.

3. Circuit selon une quelconque des revendications précédentes, **caractérisé en ce que** ledit circuit d'acheminement des signaux est une ligne de détecteur ou de communication, en particulier un bus CAN.

4. Circuit selon la revendication 1 ou 2, **caractérisé en ce que** ladite piste conductive reliée à un circuit d'acheminement des signaux ou ledit conducteur sans isolation est un câble de branchement à partir d'une ligne CAN.

5. Circuit selon une quelconque des revendications précédentes, **caractérisé en ce qu'**une logique d'analyse détecte un courant de fuite ou de défaut par l'hauteur du potentiel, par l'adultération des signaux ou par une perturbation dans le flux de données dans ledit circuit d'acheminement des signaux.

6. Circuit selon une quelconque des revendications précédentes, **caractérisé en ce qu'**il constitue une partie d'un système électronique dans un système électronique de freinage EBS.

7. Procédé actionner un circuit selon une quelconque des revendications précédentes, **caractérisé en ce que**, quand un courant de fuite ou de défaut est détecté, l'alimentation en courant est mise hors circuit.
